# EUROPÄISCHE PATENTSCHRIFT

(11) **EP 2 399 437 B1**
(45) Veröffentlichungstag und Bekanntmachung des Hinweises auf die Patenterteilung: **27.01.2016**
(21) Anmeldenummer: 10705294.6
(22) Anmeldetag: 17.02.2010
(51) Int. Cl.: H05K 7/14, G06K 17/00

(54) **SCHALTSCHRANK ODER RACK**
SWITCHGEAR CABINET OR RACK
ARMOIRE DE COMMANDE OU BAIE

(30) Priorität: 19.02.2009 DE 102009009638
(43) Veröffentlichungstag der Anmeldung: 28.12.2011
(73) Patentinhaber: Rittal GmbH & Co. KG, 35745 Herborn (DE)
(72) Erfinder: THIELMANN, Bodo, 35768 Siegbach (DE); HAIN, Markus, 35684 Dillenburg (DE); SCHMIDT, Volker, 57076 Siegen (DE)
(74) Vertreter: Angerhausen, Christoph
(86) Internationale Anmeldenummer: PCT/EP2010/000980
(87) Internationale Veröffentlichungsnummer: WO 2010/094458

(56) Entgegenhaltungen:
- WO-A1-2009/058233
- DE-A1-102007 034 437
- US-A1- 2006 171 538
- US-A1- 2008 265 722

## Beschreibung

Die Erfindung bezieht sich auf einen Schaltschrank oder ein Rack mit einer Montageeinrichtung, die einen Einbauraum für anwenderseitige Einbaueinheiten frontseitig seitlich begrenzende vertikale Montageprofile mit in einer frontseitigen Montageebene liegenden flachen Befestigungsabschnitten zum Anschlagen von seitlich abstehenden Montageabschnitten der Einbaueinheiten aufweist, und mit Komponenten einer Erfassungseinrichtung zum Feststellen, ob an einer Einbauposition des Einbauraums eine Einbaueinheit vorhanden ist oder nicht, wobei die Komponenten der Erfassungseinrichtung eine an einem Montageprofil angebrachte vertikal verlaufende Antennenleiste mit darin angeordneten Antennenelementen und an den Einbaueinheiten angeordneten, als Transponderelemente ausgebildeten Code-Trägern aufweisen, wobei das jeweilige Transponderelement mittels eines Halteelementes an dem der Antennenleiste benachbarten Montageabschnitt der zugeordneten Einbaueinheit über einen Verbindungsabschnitt angebracht ist, wobei das Halteelement einen sich an dem Verbindungsabschnitt auschließenden, parallel zur Montageebene nach außen vorstehenden Tragabschnitt aufweist.

Ein Schaltschrank oder Rack mit einer Montageeinrichtung dieser Art ist in der US 2008/265722 A1 angegeben. Hierbei sind an vertikalen Montageprofilen anwenderseitige Einbaueinheiten mit seitlich abstehenden Montageabschnitten anbringbar.

Der Schaltschrank bzw. das Rack ist mit einem intelligenten Erfassungssystem ausgerüstet, mit dem die Einbauplätze der Einbaueinheiten überwacht und ein Einbau der Einbaukomponenten feststellbar ist. Hierzu können an den Montageabschnitten RFID-Identifizierelemente angebracht werden, die mit vertikal in Reihe an einem Montageprofil angeordneten Sensorelementen zusammenwirken.

In der US 2006/171538 A1 ist ein weiterer Schaltschrank zum Aufnehmen von Einbaueinheiten und mit einem Erfassungssystem für den Einbauort der Einbaueinheiten auf der Basis von RFID-Technik gezeigt. Das RFID-Erfassungssystem weist eine an der Tür des Schaltschranks vertikal angeordnete Schaltplatine mit Sensorelementen auf.

In der nicht vorveröffentlichten WO 2009/058233 A1 ist ein Rack mit Einbaueinheiten gezeigt, die seitliche Montageabschnitte und an diesen angebrachte RFID-Elemente aufweisen, die mit an Montageprofilen des Racks angeordneten Antennenelementen zusammenarbeiten, um eingebaute Einbaueinheiten zu erfassen.

Ein weiterer Schaltschrank bzw. weiteres Rack ist in der DE 10 2007 034 437 A1 angegeben. Bei diesem bekannten Schaltschrank ist eine Vorrichtung zum Erkennen von darin aufgenommenen Einbaueinheiten mit einer Erfassungseinheit ausgerüstet, die an eine Auswerte- oder Registriereinrichtung angeschlossen oder anschließbar ist. Die Erfassungseinheit weist dabei in einer Ausgestaltung eine in der Montageebene der Einbaueinheiten angeordnete, an einem Rahmenschenkel oder Montageteil angeschraubte oder aufgeklebte Detektorleiste mit im Raster von einer oder mehreren Höheneinheiten positionierten, berührungslos ansprechenden Antennenelementen und an den Einbaueinheiten angeordnete Transponder, insbesondere RFID-Tags auf. Die leistenförmige Antennenanordnung kann sich dabei aus mehreren mit Stecker-/Kupplungseinheiten zusammengesteckten Antennenmodulen zusammensetzen, die jeweils ein schmales, sich längs erstreckendes, leistenartiges Kunststoffgehäuse zur Abdeckung mehrerer Höheneinheiten aufweisen. Das Gehäuse, das sich auch über die gesamte Höhe des Aufnahmebereichs für die Einbaueinheiten erstrecken kann, besitzt Befestigungsmöglichkeiten zum Anbringen z. B. an einer vertikalen Montageschiene, an der auch die Einbaueinheiten festgelegt sind. Die Transponder bzw. RFID-Tags sind im vorderen Bereich der Einbaueinheiten, insbesondere Servereinheiten, an deren Gehäuse nahe der Detektorleiste positioniert, so dass die Antennenelemente im Nahfeld der jeweils zugeordneten Transponder deren Information auslesen, die über eine Datenleitung oder alternativ drahtlos zu der Auswerte- und Registriereinrichtung übertragen wird. Das jeweilige RFID-Tag besitzt eine eindeutige Identifikation und kennzeichnet die zu erfassende Einbaueinheit, die über die betreffenden Antennenelemente unter Steuerung durch eine Steuereinheit ausgelesen und mit der zugehörigen Höhenposition an die Auswerteeinheit übermittelt wird. Die Befestigung der RFID-Tags an der Einbaueinheit erfolgt durch Kleben oder Schrauben. Die eindeutige Identifikation des so aufgebauten passiven Transponders bzw. RFID-Tags erfolgt bereits im Herstellungswerk.

Zwar ergibt die Anordnung der Detektorleiste im Bereich der Einbauebene des Schaltschranks oder Racks vorteilhafte Montagemöglichkeiten und eine günstige Signalerfassung in Verbindung mit den Transpondem. Jedoch kann es durch ungenaue Montage zu Störungen in der Signalerfassung und Signalübertragung und damit unzuverlässiger Positionserfassung oder Zuordnung von Identifikationen kommen.

Der Erfindung liegt die Aufgabe zugrunde, einen Schaltschrank oder Rack der eingangs genannten Art bereitzustellen, bei dem eine ungenaue oder fehlerhafte Montage der Erfassungseinrichtung möglichst ausgeschlossen wird.

Diese Aufgabe wird mit den Merkmalen des Anspruches 1 gelöst. Hierbei ist vorgesehen, dass sich das jeweilige Transponderelement auf einem seitlich abstehenden Zungenartigen Tragabschnitt befindet, der die in einem Montageprofil eingesetzte Antennenleiste frautseitig überlappt.

Mit diesen Maßnahmen werden eine eindeutige, genaue Montage der Transponderelemente und eine exakte Zuordnung der Transponderelemente zu in der Antennenleiste vorhandenen Antennenelementen erreicht.

Eine vorteilhafte Montage wird dadurch begünstigt, dass das Halteelement flach ausgebildet ist und mit seinem Verbindungsabschnitt auf der ebenfalls flach ausgebildeten Rückseite des Montageabschnitts angeordnet und mit diesem gegen die Vorderseite des Befestigungsabschnittes gedrückt ist.

Die Anbringung wird dabei dadurch begünstigt, dass der Verbindungsabschnitt auf den Montageabschnitt aufgeklebt ist.

Für eine einfache und genaue Montage sind ferner die Maßnahmen von Vorteil, dass der Befestigungsabschnitt mit einer Lochreihe von in einem gleichmäßigen Rasterabstand angeordneten Befestigungslöchern versehen ist, dass in dem Montageabschnitt ein oder mehrere auf die Position der Befestigungslöcher abgestimmte Montagelöcher angeordnet sind und dass auch in dem Verbindungsabschnitt auf die Position der Montagelöcher abgestimmte Öffnungen angeordnet sind.

Eine stabile, lagegenaue Anbringung wird dadurch erhalten, dass sich der Verbindungsabschnitt in Längsrichtung des Montageprofils über die Höhe des Montageabschnittes, insbesondere eine Höheneinheit HE, erstreckt und sich zur Außenseite bis zu dem freien Rand des Montageabschnittes erstreckt.

Zusätzliche Positionserkennungsmöglichkeiten werden dadurch ermöglicht, dass der Tragabschnitt sich in der Höhe über einen Bruchteil des Verbindungsabschnittes erstreckt.

Ist vorgesehen, dass die Antennenleiste mit ihrer Frontseite in der Montageebene liegt oder gegenüber dieser um höchstens 10 mm zurückversetzt ist und dass der Tragabschnitt mit dem Transponderelement im eingebauten Zustand der zugehörigen Einbaueinheit die Frontseite der Antennenleiste überlappt, so wird die Übertragungssicherheit erhöht.

Die Montage und eine sichere Funktion werden auch dadurch begünstigt, dass das Montageprofil eine an den Querschnitt der Antennenleiste zumindest teilweise angepasste Aufnahme mit einem gegenüber der Montageebene zumindest um die Querschnittstiefe der Antennenleiste zurückversetzten Anlageabschnitt und mit einer die Aufnahme auf deren dem Einbauraum zugekehrter Seite begrenzenden innenseitigen Begrenzungswand aufweist, die in den Befestigungsabschnitt übergeht.

Eine für eine genaue Montage vorteilhafte Ausgestaltung besteht darin, dass der Anlageabschnitt und die innenseitige Begrenzungswand 13 im Querschnitt der Aufnahme rechtwinklig zueinander angeordnet sind, wobei der Anlageabschnitt parallel zur Montageebene ausgerichtet ist und die Begrenzungswand rechtwinklig in den Befestigungsabschnitt übergeht, insbesondere wenn weiter vorgesehen ist, dass die Antennenleiste quadratischen oder rechteckförmigen Querschnitt besitzt.

Vorteilhafte Anbringungsmöglichkeiten werden ferner dadurch erreicht, dass in dem Anlageabschnitt eine Haltelochreihe mit in regelmäßigem Rasterabstand angeordneten Haltelöchern angeordnet ist, wobei die Haltelöcher quadratisch oder rechteckförmig mit in Längsrichtung des Montageprofils verlaufenden Längsseiten ausgebildet sind, dass die Antennenleiste auf ihrer dem Anlageabschnitt zugekehrten Rückseite mit Haltehaken versehen ist, die auf den Abstand der Haltelöcher oder ein Vielfaches davon abgestimmt sind und vertikale Hakenabschnitte aufweisen, die eine geringere Länge besitzen als die lichte Öffnungsweite der Haltelöcher in vertikaler Richtung und die soweit von der rückseitigen Außenfläche der Antennenleiste beabstandet sind, dass sie einen die Haltelöcher umgebenden Wandbereich des Anlageabschnitts mit einer Klemmkraft hintergreifen, und dass im Inneren der Antennenleiste im Raster einer Höheneinheit HE oder einem ganzzahligen Vielfachen oder gleichmäßigen Teilabstand davon in Längsrichtung der Antenneneinheit voneinander beabstandete Antennenelemente angeordnet sind. Diese Maßnahmen tragen auch zu einer zuverlässigen Funktion bei.

Zum Erkennen der Einbaulage ist weiterhin vorteilhaft, dass die Antennenleiste bezüglich ihrer Einbaulage auf ihrer Frontseite mit einem daran fest oder abnehmbar angebrachten Abdeckteil versehen ist, das zumindest abschnittsweise transparent ausgebildet ist, dass im Inneren der Antennenleiste Leuchtelemente angeordnet sind, die in Längsrichtung der Antennenleiste in gleichmäßigem Rasterabstand im Raster einer Höheneinheit HE oder einem ganzzahligen Vielfachen oder gleichmäßigen Teilabstand davon angeordnet, getrennt ansteuerbar und im Leuchtzustand durch das transparente Abdeckteil positionsgenau sichtbar sind, und dass der Tragabschnitt lichtundurchlässig ausgebildet ist und zumindest ein Leuchtelement frontseitig abdeckt.

Die Erfindung wird nachfolgend anhand von Ausführungsbeispielen unter Bezugnahme auf die Zeichnungen näher erläutert. Es zeigen:
- Fig. 1: eine frontseitige Montageebene eines Schaltschranks oder Racks,
- Fig. 2: einen Ausschnitt eines Einbauraums eines Schaltschranks oder Racks mit vorderer Montageebene und vertikalen Montageprofilen in perspektivischer Ansicht,
- Fig. 3: einen Ausschnitt der Montageebene im Bereich eines Montageabschnittes,
- Fig. 4: eine Detailansicht des Schaltschranks oder Racks in einem oberen vorderen Eckbereich des Einbauraums und der Montageebene mit mehreren eingesetzten Einbaueinheiten,
- Fig. 5: einen Ausschnitt des Schaltschranks oder Racks in einem oberen vorderen Eckbereich mit einer eingesetzten Antennenleiste und einem Halteelement mit Transponder in perspektivischer Ansicht,
- Fig. 6: einen Ausschnitt der Befestigungsebene im Bereich eines Montageabschnittes mit vertikalem Montageprofil, eingesetzter Antennenleiste und angebrachtem Halteelement mit Transponder,
- Fig. 7A bis 7C: eine perspektivische Ansicht, eine Vorderansicht und eine Ansicht auf die rückseitige Stirnseite eines Halteelementes mit Transponderelement,
- Fig. 8: eine perspektivische Ausschnittdarstellung des vorderen oberen Eckbereichs des Schaltschranks oder Racks mit einer Antennenleiste vor deren Einbau,
- Fig. 9A bis 9D: in Fig. 9A eine perspektivische Ansicht eines Abschnitts der Antennenleiste schräg auf die Rückseite; in den Teilbildern a), b) und c) der Fig. 9B die Antennenleiste von der Vorderseite, in einer seitlichen Ansicht und von der Rückseite; in Fig. 9C einen Längsschnitt der Antennenleiste sowie in Fig. 9D einen Querschnitt der Antennenleiste,
- Fig. 10: verschiedene Ansichten des vorderen Montagerahmens des Schaltschranks oder Racks mit seitlichen vertikalen Montageprofilen und einem unteren und oberen Rahmenschenkel sowie vergrößerten Ausschnittdarstellungen,
- Fig. 11: den vorderen Montagerahmen des Schaltschranks oder Racks in perspektivischer Ansicht,
- Fig. 12: einen Ausschnitt des Montagerahmens nach Fig. 11 im Verbindungsbereich zweier auseinander geschobener Leistenmodule und
- Fig. 13: ein Beispiel für eine Bildschirmdarstellung einer Einbauebene eines Schaltschranks oder Racks mit eingesetzten Einbaueinheiten in Form von Servereinheiten.

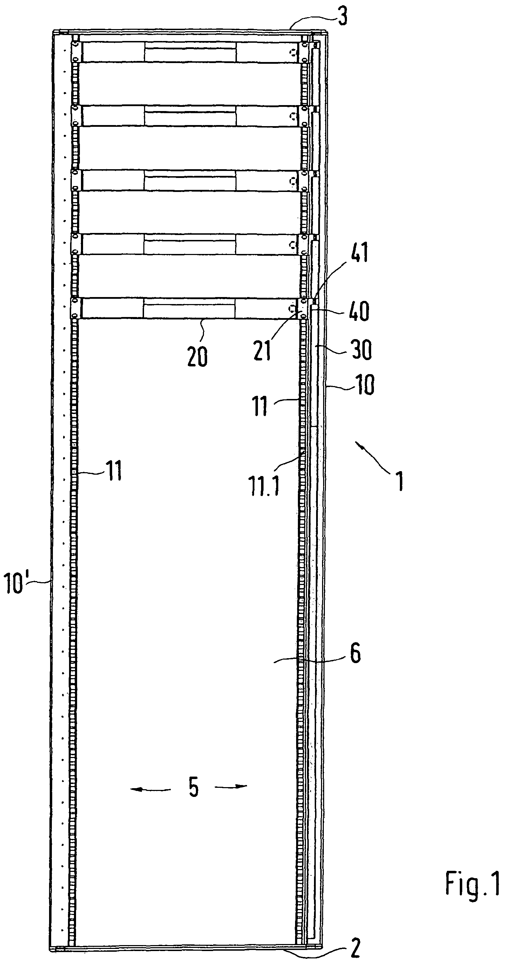

Fig. 1 zeigt eine vorderseitige Ansicht einer Montageebene 5 eines Rahmengestells 1 eines Schaltschranks oder Racks mit mehreren eingebauten Einbaueinheiten 20, wie z. B. Servereinheiten, deren Höhe beispielsweise eine HE beträgt. Die Montageebene 5 ist seitlich durch frontseitige Montageflächen zweier vertikaler Montageprofile 10, 10' und unten von einem unteren Rahmenschenkel 2 sowie oben von einem oberen Rahmenschenkel 3 begrenzt. An den die lichte Einbauöffnung begrenzenden Ränder der Montageprofile 10, 10' schließen sich beidseitig Befestigungsabschnitte 11 der Montageprofile mit Lochreihen 11.1 an, die einen engen Lochrasterabstand von vorliegend drei Befestigungslöchern pro Höheneinheit HE besitzen. Die Montageprofile 10, 10' können durch seitliche Rahmenprofile des Rahmengestells und/oder durch separate Montageprofile gebildet sein.

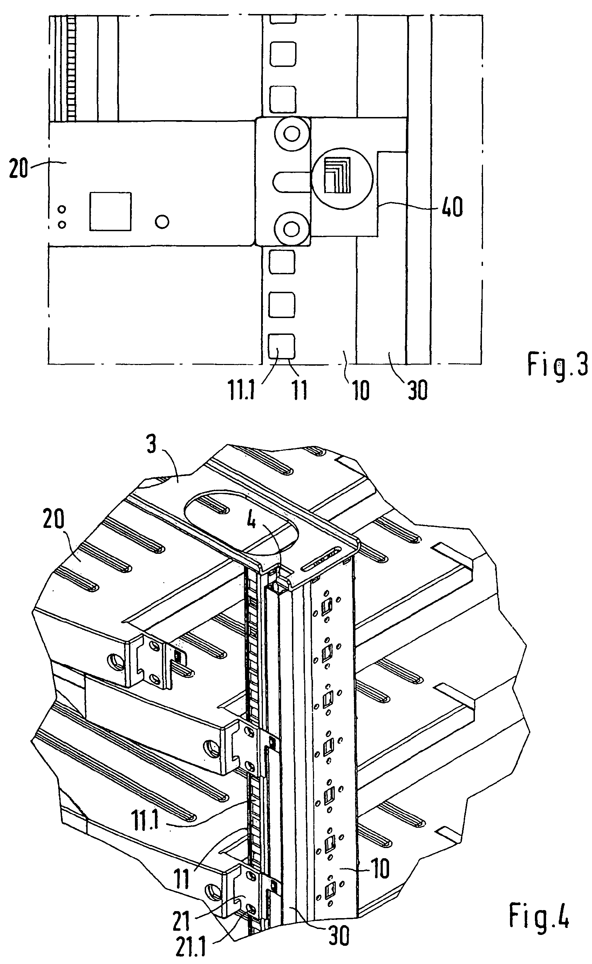

Die Einbaueinheiten 20 weisen seitlich abstehende flache Montageabschnitte 21 auf, die sich über die Gehäusehöhe der Einbaueinheiten 20, beispielsweise eine oder mehrere Höheneinheiten HE, erstrecken und über die beiderseitigen Befestigungsabschnitte 11 vorstehen. In den Montageabschnitten 21 sind z. B. jeweils zwei Montagelöcher 21.1 (vgl. z. B. auch Fig. 4) vorliegend im doppelten Abstand der Befestigungslöcher 11.2 der Lochreihe 11.1 eingebracht, so dass die Montagelöcher 21.1 jeweils ein Befestigungsloch 11.2 überspringen.

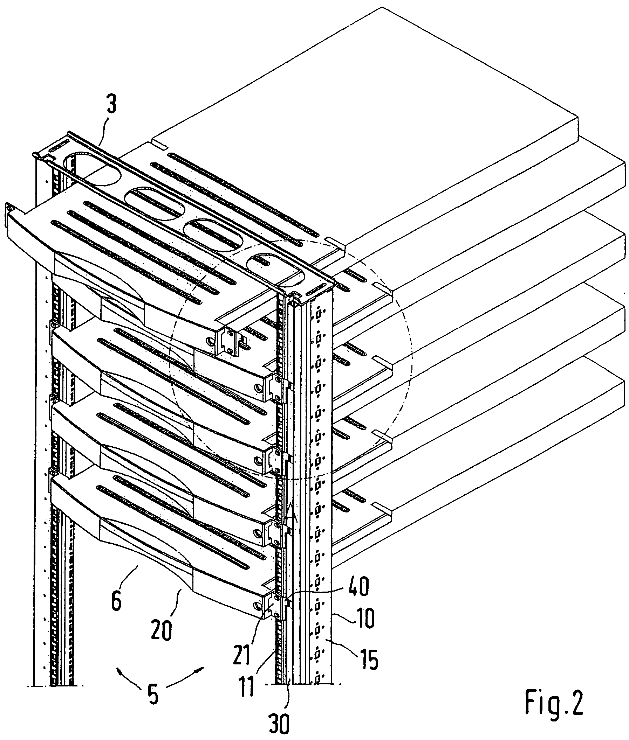

Im Bereich eines seitlichen Montageabschnittes, vorliegend des in Vorderansicht rechten Montageabschnittes 21, sind jeweils Halteelemente 40 angeordnet, beispielsweise an dem Montageabschnitt 21 festgeklebt oder zumindest zwischen diesem und dem Befestigungsabschnitt 11 eingeklemmt, wobei ein zungenartiger Tragabschnitt 41 mit einem darauf angebrachten Transponderelement 44 seitlich absteht und eine in dem Montageprofil 10 eingesetzte Antennenleiste 30 frontseitig überlappt, wie der Ausschnittsdarstellung nach Fig. 2 und den weiteren Darstellungen nach den Fig. 3, 4 und 5 deutlicher zu entnehmen ist.

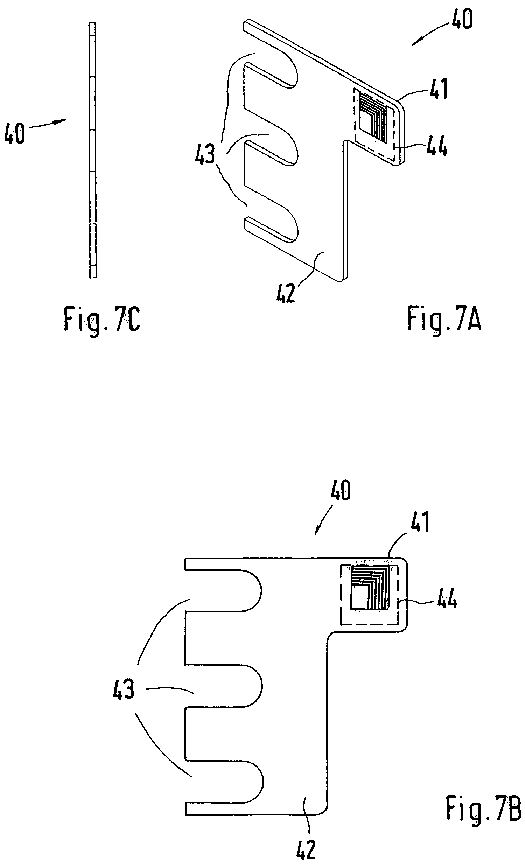

In den Fig. 7A, 7B, 7C ist das Halteelement 40 einzeln in verschiedenen Ansichten wiedergegeben. Die Halteelemente 40 sind aus flachem, plattenförmigem Material geringer Stärke von z. B. höchstens etwa 1 mm beispielsweise aus Metall oder Kunststoff hergestellt, vorzugsweise durch Stanzen oder Schneiden oder aber durch Formen. Das Halteelement 40 weist einen Verbindungsabschnitt 42 mit darin eingebrachten Öffnungen 43 auf, die zu dem von dem Tragabschnitt 41 abgelegenen Rand hin offen sind und eine portalförmige Kontur besitzen. Die im montierten Zustand vertikale Höhenausdehnung entspricht vorzugsweise der Höhe des Montageabschnitts 21, der in der Regel der Gehäusehöhe einer Einbaueinheit, also z. B. einer oder mehreren Höheneinheiten HE entspricht, während die seitliche Breitenausdehnung des Verbindungsabschnitts 42 in etwa der Breite des Montageabschnittes 21 entspricht, so dass im Montagezustand der außenseitige Rand des Verbindungsabschnitts 42 mit dem außenseitigen Rand des Montageabschnitts 21 in etwa bündig ist und auch der obere und untere Rand des Verbindungsabschnitts 42 und des Montageabschnittes 21 in etwa bündig sind. Der sich nur über einen Bruchteil, z. B. ½, 1/3, ¼ der Höhe des Verbindungsabschnitts 42 erstreckende Tragabschnitt 41, dessen oberer Rand beispielsweise in Verlängerung des oberen Randes des Verbindungsabschnittes verläuft, ist vorzugsweise lichtundurchlässig ausgebildet und trägt das darauf z. B. durch Kleben befestigte Transponderelement 44, insbesondere ausgebildet als RFID-Tag.

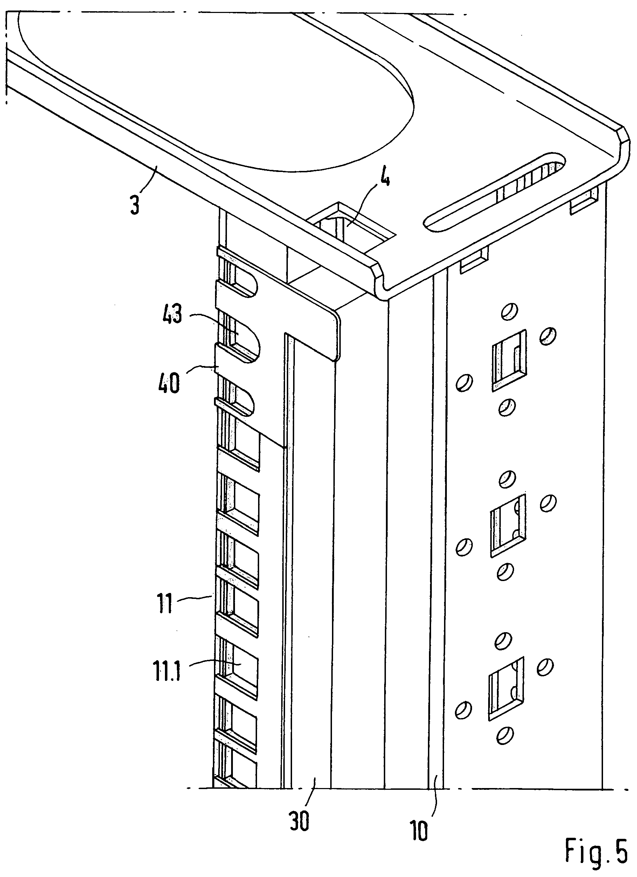

Wie Fig. 2 in perspektivischer Darstellung zeigt, sind die Halteelemente 40, die aus flachem blättchenförmigem Material beispielsweise aus Metall oder Kunststoff hergestellt sind, mit dem Verbindungsabschnitt 42 zwischen der flachen Rückseite des betreffenden Montageabschnittes 21 und der flachen Vorderseite des Befestigungsabschnittes 11 festgespannt, wobei sie zuvor vorteilhaft an dem jeweiligen Montageabschnitt 21 fixiert wurden, beispielsweise mittels einer auf ihnen angebrachten Klebeschicht, die im nicht angebrachten Zustand von einer ablösbaren Schutzfolie abgedeckt ist. In dem Verbindungsabschnitt 42 sind auf die Montagelöcher 21.1 in Lage und Größe abgestimmte Öffnungen 43 eingebracht, so dass die in den Einbauraum 6 eingesetzten und mit ihren Montageabschnitten 21 an den Befestigungsabschnitten 11 anliegenden Einbaueinheiten 20 mittels Schrauben oder ähnlichen Befestigungselementen ungehindert an den Befestigungsabschnitten 11 befestigt werden können, wie Fig. 3 zeigt. Wie ferner aus Fig. 5 ersichtlich, sind dabei auch die Öffnungen 43 der Verbindungsabschnitte 42 mit den betreffenden Befestigungslöchern 11.2 der Lochreihen 11.1 in Deckung gebracht.

Wie die Fig. 2 und insbesondere die vergrößerte Ausschnittsdarstellung nach Fig. 4 sowie auch die Fig. 5, 6 und 8 weiter zeigen, ist zumindest das in Draufsicht rechte Montageprofil, dem die Antennenleiste 30 zugeordnet ist, zur Außenseite an den betreffenden Befestigungsabschnitt 11 anschließend mit einer innenseitigen Begrenzungswand 13 einer Aufnahme 14 für die Antennenleiste 30 versehen. Die innenseitige Begrenzungswand 13 geht an ihrem von der Frontseite abliegenden rückseitigen Ende rechtwinklig in einen nach außen zeigenden Anlageabschnitt 12 in der Tiefe der Aufnahme 14 über, an die die Antennenleiste 30 beim Einsetzen in Anlage gebracht wird. Dabei ist die Vorderseite des Anlageabschnittes 12 von der frontseitigen Montageebene bzw. der Ebene des Befestigungsabschnittes 11 in einem solchen Abstand zurück versetzt, dass die Antennenleiste 30 mit ihrer Vorderseite nicht über die Frontebene des Befestigungsabschnittes 11 übersteht und vorzugsweise mit dieser bündig ist oder nur wenig, z. B. nicht mehr als 10 mm zurückversetzt ist. Besonders bei bündiger Anordnung der Vorderseite der Antennenleiste 30 in der vorderen Montageebene ist der Tragabschnitt 41, auf dessen Rückseite ein insbesondere als RFID-Tag ausgebildetes Transponderelement 44 angebracht ist und der die Frontseite der Antennenleiste 30 überlappt, in möglichst geringem Abstand zur Antennenleiste 30 und darin enthaltenen Antennenelementen angeordnet, so dass sich eine geringe Übertragungsdistanz für die Informationsübertragung zwischen Transponderelement 44 und dem betreffenden Antennenelement ergibt.

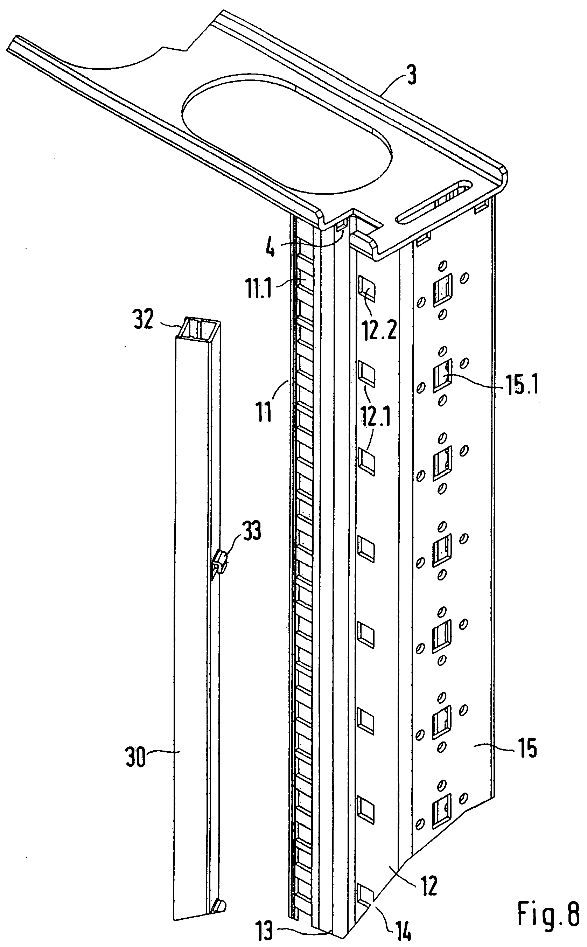

Wie aus Fig. 8 weiter ersichtlich, ist in dem Anlageabschnitt 12 eine Haltelochreihe 12.1 mit mindestens zwei Haltelöchern 12.2 eingebracht, die einen gleichmäßigen Lochrasterabstand in vertikaler Richtung aufweisen, beispielsweise im Abstand einer oder mehrerer Höheneinheiten. Die Haltelöcher 12.2 sind rechteckförmig oder quadratisch geformt und mit ihren Lochbegrenzungsseiten horizontal bzw. vertikal bezüglich der Längsrichtung des Montageprofils 10 bzw. 10' ausgerichtet. Die Antennenleiste 30 ist auf ihrer Rückseite mit Hakenelementen 33 versehen, die beispielsweise durch teilweises Ausstanzen und Ausbiegen aus deren Rückwand hergestellt sind, wobei nach unten gerichtete Hakennasen gebildet sind, die von der Rückwandebene der Antennenleiste 30 um etwas weniger als die Stärke der Wandung des Anlageabschnittes 12 um die Haltelöcher 12.2 beabstandet sind, wobei der nach unten gerichtete Abschnitt an seinem unteren Endabschnitt nach außen von der Rückwandebene der Antennenleiste 30 weggebogen ist, so dass sich ein einfaches Einhängen ergibt. Der nach unten gerichtete Hakenabschnitt ist dabei kürzer als die vertikale Öffnungsweite der Haltelöcher 12.2. Über die Länge der Antennenleiste 30 sind mehrere derartige Hakenelemente angeordnet, die auf den Lochrasterabstand der Haltelöcher 12.2 oder ein Mehrfaches davon abgestimmt sind. Außerdem ist die Breite der Haken auf die Breite der Haltelöcher 12.2 derart abgestimmt, dass sie mit möglichst geringem seitlichem Spiel in die Haltelöcher 12.2 passen. Mit diesen Maßnahmen kann die Antennenleiste 30 einfach und lagegenau in die Aufnahme 14 eingesetzt und mit ihrer Rückseite in Anlage an die Vorderseite des Anlageabschnittes 12 gebracht und anschließend durch Verschieben nach unten fixiert werden, wobei die Haltehaken 33 eine leichte Klemmwirkung ergeben.

Wie Fig. 8 weiter zeigt, ist in dem oberen horizontalen Rahmenschenkel 3, der auch ein Montageschenkel sein kann, fluchtend bezüglich der eingesetzten Antennenleiste 30 eine Ausnehmung 4 eingebracht, die mindestens so groß ist wie der Außenquerschnitt der Antennenleiste 30, so dass diese auch dann ungehindert eingesetzt werden kann, wenn sie sich im eingesetzten Zustand bis in den Bereich des oberen Endes der vertikalen Montageprofils 10 bzw. 10' erstreckt, um auch die obere Einbauposition des Einbauraums 6 auszunutzen. Auf diese Weise kann die Antennenleiste 30 über das vertikale Rahmenprofil 10 bzw. 10' hinausstehend eingesetzt und dann nach unten verschoben werden, um sie zu fixieren.

Wie die Fig. 2, 4, 5 und 8 weiter zeigen, geht der Anlageabschnitt 12 an seinem außenseitigen Rand in einen außenseitigen Seitenwandabschnitt 15 des Montageprofils 10 bzw. 10' über, der nach hinten gerichtet ist, und in dem eine weitere vertikale Lochreihe 15.1 mit Löchern für Montagezwecke angeordnet ist. Die Aufnahme 14 könnte auch auf ihrer Außenseite mit einer weiteren Wand parallel zur innenseitigen Begrenzungswand 13 versehen sein, die mit ihrem vorderen Rand höchstens bis in die frontseitige Montageebene vorsteht.

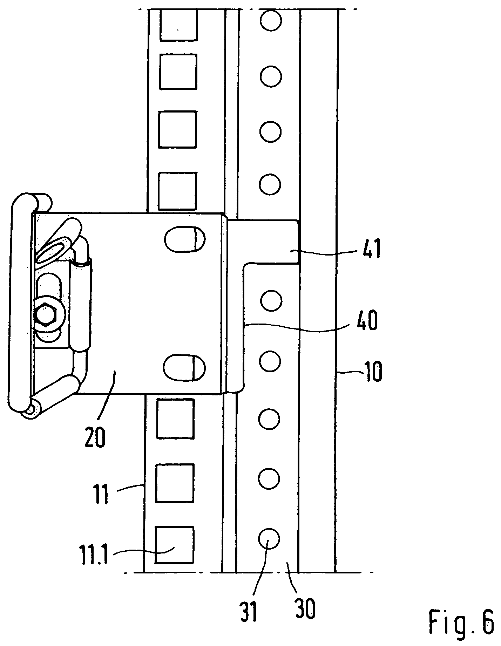

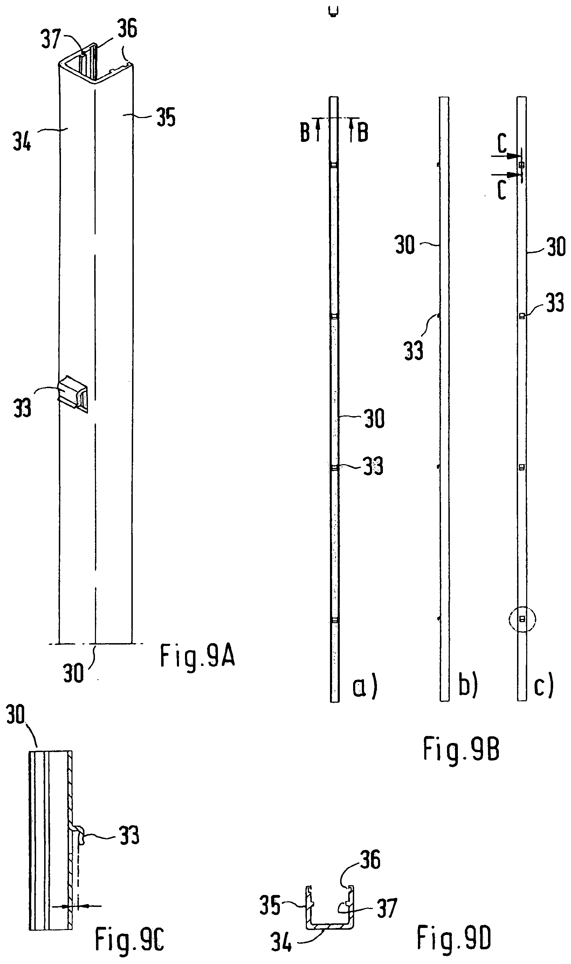

Wie Fig. 8 und weiterhin die Fig. 9A bis 9D zeigen, besitzt die Antennenleiste 30 ein Gehäuse mit U-förmigem, z. B. quadratischem oder rechtförmigem Querschnitt mit einem Basisschenkel 34 und zwei Seitenschenkeln 35. In die im eingebauten Zustand zur Frontseite des Schaltschranks bzw. Racks gerichtete vordere Seite ist ein Abdeckteil 32 eingesetzt, beispielsweise eingeschnappt oder eingerastet. Zum Halten des Abdeckteils 32 sind auf der Innenseite der Seitenschenkel 35 in der Nähe des freien Randes derselben längs verlaufende Haltenuten 36 ausgebildet, die die freien Ränder des vorzugsweise flachen Abdeckteils 32 vorderseitig und rückseitig überfassen. Das Abdeckteil 32 kann auch oder zusätzlich eingeklebt werden. Außerdem sind, gegenüber den Haltenuten 36 tiefer nach innen versetzt, auf der Innenseite der Seitenschenkel 35 sich gegenüberliegende Halterippen 37 eingebracht, so dass im Inneren des U-förmigen Gehäuses der Antennenleiste 30 weitere Elemente beispielsweise mittels Halteplättchen fixiert werden können, wie z. B. die genannten Antennenelemente und Zuführleitungen sowie auch später noch beschriebene Leuchtelemente 31 (vgl. Fig. 6). Das Abdeckteil 32 ist vorzugsweise lichtdurchlässig durchscheinend bzw. transparent ausgebildet, so dass Licht der Leuchtelemente 31 durchtritt, wobei die Leuchtelemente klar umgrenzt in ihrer Position individuell erkennbar sind, jedoch der Innenraum der Antennenleiste 30 vorzugsweise nicht einsehbar ist. Hierzu eignet sich entsprechend eingetrübtes Glas mit möglichst geringer Lichtschwächung und z. B. ohne selektive spektrale Filtereigenschaften.

Wie Fig. 6 zeigt, sind die Leuchtelemente 31 ebenfalls in einem gleichmäßigen Rasterabstand über die Länge der Antennenleiste 30 angeordnet, wobei z. B. drei Leuchtelemente 31 pro Höheneinheit HE eingesetzt sind. Zwei der Leuchtelemente 31 liegen dabei neben dem Montageabschnitt 21 bzw. Verbindungsabschnitt 42 des Halteelementes 40 frei, und befinden sich bei eingesetzter Einbaueinheit 20 z. B. im angesteuerten leuchtenden Zustand, während ein drittes Leuchtelement 31 pro Höheneinheit bei eingesetzter Einbaueinheit 20 von dem vorzugsweise lichtundurchlässigen Tragabschnitt 41 des Halteelementes 40 abgedeckt ist, das sich in vertikaler Richtung nur über ein Drittel einer Höheneinheit HE erstreckt. Auf diese Weise werden einem Betrachter die Einbaulagen auch visuell gut erkennbar angezeigt, wobei besetzte Einbaupositionen leicht wahrnehmbar sind. Die Leuchtelemente 31 können über (eine nicht gezeigte) Steuereinheit, wie sie beispielsweise in der eingangs genannten DE 10 2007 034 437 A1 angegeben ist, angesteuert werden, wobei verschiedene Ansteuerungsweisen in Frage kommen, z. B. in verschiedenen Farben unter Einsatz von verschiedenfarbig betreibbaren Leuchtdioden, oder in verschiedenen Blinkmodi bzw. im Dauerlichtbetrieb. Die Leuchtelemente 31 werden dabei in Abhängigkeit von den von den Transponderelementen 44 erhaltenen und über die Antennenelemente an die Steuereinheit weitergeleiteten Informationen angesteuert. Die Antennenelemente können im selben Rasterabstand und in enger Nähe zu den Leuchtelementen 31 angeordnet sein, so dass sich eine eindeutige Informationserfassung und Positionszuordnung erreichen lässt. Weitere Signalisierungen können in Abhängigkeit von dem Betriebszustand der Einbaueinheiten, ihren in den Transponderelementen 44 z. B. werkseitig programmierten Eigenschaften und ihrer Einbaulage gesteuert werden, wobei die Steuereinheit auch mit einer übergeordneten Überwachungseinrichtung und Registrierungseinrichtungen zusammenarbeiten kann.

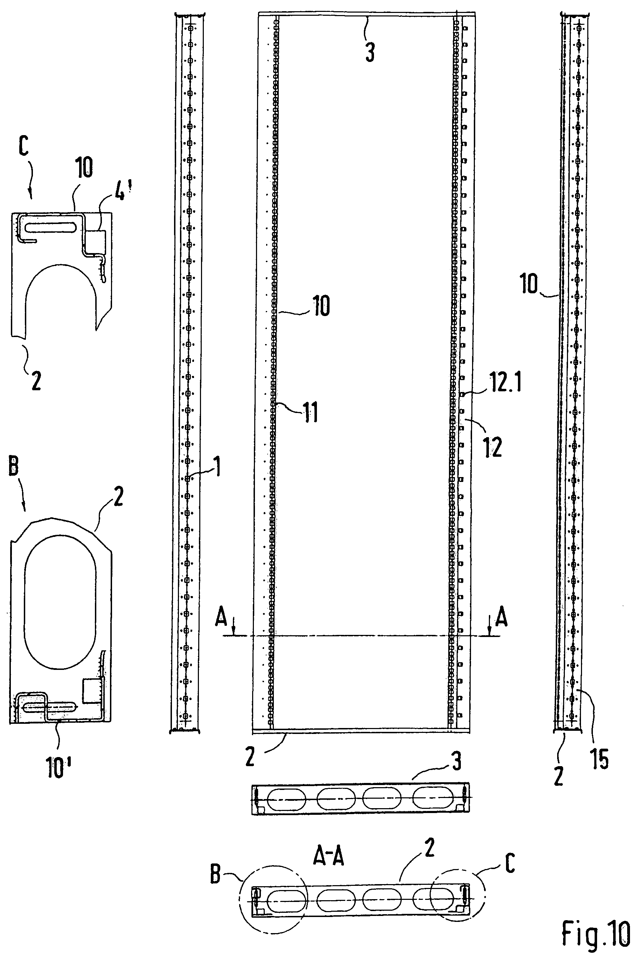

Wie Fig. 10 zeigt, kann auch in dem unteren Rahmenschenkel 2 eine Ausnehmung 4' zum Verschieben der Antennenleiste 30 nach unten eingebracht sein. Die beiden vertikalen Montageprofile 10, 10' können gleichen oder unterschiedlichen Aufbau aufweisen, wie die vergrößerten Ausschnitte B und C zeigen.

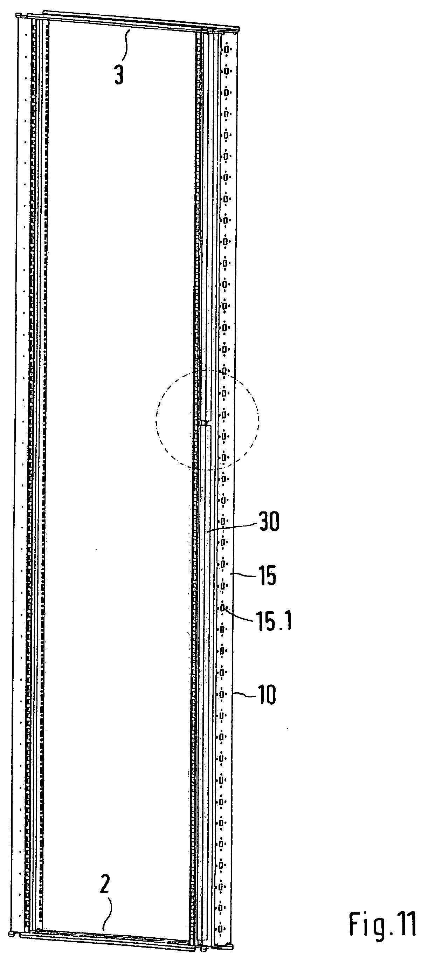

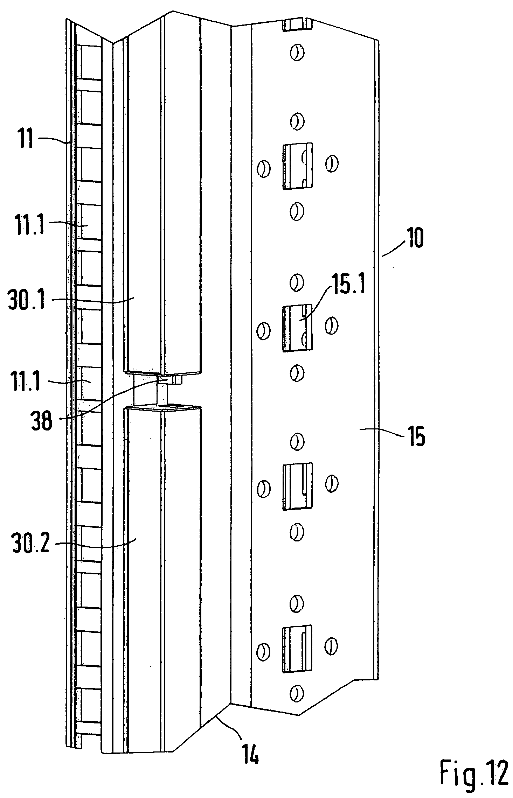

Wie die Fig. 11 und die vergrößerte Ausschnittdarstellung in Fig. 12 zeigen, kann die Antennenleiste 30 aus mehreren Leistenmodulen 30.1, 30.2 zusammengesetzt sein, die über eine Stecker-/Kupplungseinheit elektrisch leitend zusammengesteckt werden können, wobei sich auch eine mechanische Verbindung ergibt, die aber zusätzlich noch mittels Rastelementen oder anderen Steckelementen ergänzt sein kann. Die Leistenmodule 30.1, 30.2 erstrecken sich vorzugsweise über mehrere Höheneinheiten und besitzen eine Länge, die auf verschiedene gängige Schaltschrankhöhen abgestimmt ist, so dass das kleinste Modul in einen Schaltschrank niedrigster Höhe passt und eine Antennenleiste 30 für einen höheren Schaltschrank durch Zusammenstecken mehrerer Leistenmodule 30.1, 30.2 erhalten wird.

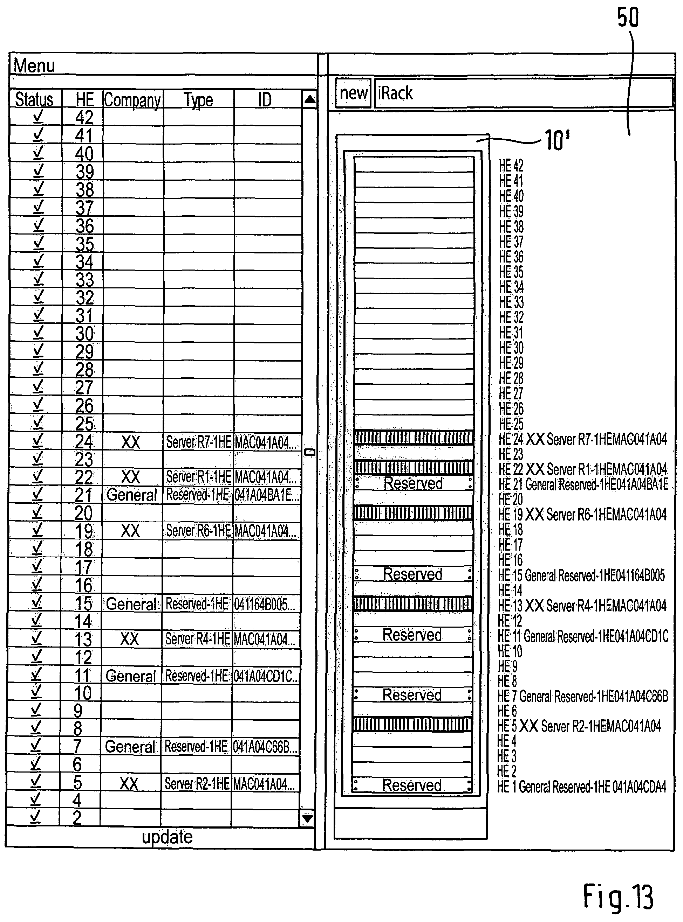

Fig. 13 zeigt ein Beispiel für eine Anzeige auf einem Sichtschirm einer entfernten Anzeigestation, wobei auf einer Bildschirmanzeige 50 die Montageebene eines Schaltschranks oder Racks mit seinen Höheneinheiten HE1 bis HE42 mit belegten Einbaupositionen dargestellt ist. Ferner sind neben der Einbauebene Zusatzinformationen zu den einzelnen Einbaueinheiten, beispielsweise Servereinheiten, eingeblendet, die den aktuellen Status und Eigenschaften der Einbaueinheiten 20 wiedergeben. Derartige Informationen können auf den Transponderelementen 44, insbesondere RFID-Tags, zum Teil gespeichert, zum anderen Teil erzeugt werden und über die Antennenelemente und die Steuereinheit weitergeleitet werden. Auch können die auf den RFID-Tags enthaltenen und an die Steuereinheit, Registriereinrichtung bzw. übergeordnete Überwachungseinrichtung weitergeleiteten Informationen mit dort gespeicherten weiteren Informationen zu den Einbaueinheiten 20, wie z. B. technischen Daten, ergänzt werden.

## Patentansprüche

1. Schaltschrank oder Rack mit einer Montageeinrichtung, die einen Einbauraum (6) für anwenderseitige Einbaueinheiten (20) frontseitig seitlich begrenzende vertikale Montageprofile (10, 10') mit in einer frontseitigen Montageebene (5) liegenden flachen Befestigungsabschnitten (11) zum Anschlagen von seitlich abstehenden Montageabschnitten (21) der Einbaueinheiten (20) aufweist, und mit Komponenten einer Erfassungseinrichtung zum Feststellen, ob an einer Einbauposition des Einbauraums (6) eine Einbaueinheit (20) vorhanden ist oder nicht, wobei die Komponenten der Erfassungseinrichtung eine an einem Montageprofil (10) angebrachte vertikal verlaufende Antennenleiste (30) mit darin angeordneten Antennenelementen und an den Einbaueinheiten (20) angeordneten, als Transponderelemente (44) ausgebildeten Code-Trägern aufweisen, wobei das jeweilige Transponderelement (44) mittels eines Halteelementes (40) an dem der Antennenleiste (30) benachbarten Montageabschnitt (21) der zugeordneten Einbaueinheit (20) über einen Verbindungsabschnitt (42) angebracht ist, wobei dass das Halteelement (40) einen sich an den Verbindungsabschnitt (42) anschließenden, parallel zur Montageebene nach außen vorstehenden Tragabschnitt (41) aufweist, **dadurch gekennzeichnet, dass** sich das jeweilige Transponderelement (44) auf einem seitlich abstehenden, zungenartigen Tragabschnitt (41) befindet, der die in einem Montageprofil (10) eingesetzte Antennenleiste (30) frontseitig überlappt.

2. Schaltschrank oder Rack nach Anspruch 1, **dadurch gekennzeichnet, dass** das Halteelement (40) flach ausgebildet ist und mit seinem Verbindungsabschnitt (42) auf der ebenfalls flach ausgebildeten Rückseite des Montageabschnitts (21) angeordnet und mit diesem gegen die Vorderseite des Befestigungsabschnittes (11) gedrückt ist.

3. Schaltschrank oder Rack nach Anspruch 1 oder 2, **dadurch gekennzeichnet, dass** der Verbindungsabschnitt (42) auf den Montageabschnitt (21) aufgeklebt ist.

4. Schaltschrank oder Rack nach einem der vorhergehenden Ansprüche, **dadurch gekennzeichnet**, das der Befestigungsabschnitt (11) mit einer Lochreihe (11.1) von in einem gleichmäßigen Rasterabstand angeordneten Befestigungslöchern (11.2) versehen ist,
dass in dem Montageabschnitt (21) ein oder mehrere auf die Position der Befestigungslöcher (11.2) abgestimmte Montagelöcher (21.1) angeordnet ist/sind und dass auch in dem Verbindungsabschnitt (42) auf die Position der Montagelöcher (21.1) abgestimmte Öffnungen (43) angeordnet sind.

5. Schaltschrank oder Rack nach einem der vorhergehenden Ansprüche, **dadurch gekennzeichnet, dass** sich der Verbindungsabschnitt (42) in Längsrichtung des Montageprofils (10) über die Höhe des Montageabschnittes (21), insbesondere eine Höheneinheit HE, erstreckt und sich zur Außenseite bis zu dem freien Rand des Montageabschnittes (21) erstreckt.

6. Schaltschrank oder Rack nach einem der vorhergehenden Ansprüche, **dadurch gekennzeichnet, dass** der Tragabschnitt (41) sich in der Höhe über einen Bruchteil des Verbindungsabschnittes (42) erstreckt.

7. Schaltschrank oder Rack nach einem der vorhergehenden Ansprüche, **dadurch gekennzeichnet, dass** die Antennenleiste (30) mit ihrer Frontseite in der Montageebene (5) liegt oder gegenüber dieser um höchstens 10 mm zurückversetzt ist.

8. Schaltschrank oder Rack nach Anspruch 7, **dadurch gekennzeichnet, dass** das Montageprofil (10) eine an den Querschnitt der Antennenleiste (30) zumindest teilweise angepasste Aufnahme (14) mit einem gegenüber der Montageebene (5) zumindest um die Querschnittstiefe der Antennenleiste (30) zurückversetzten Anlageabschnitt (12) und mit einer die Aufnahme (14) auf deren dem Einbauraum (6) zugekehrter Seite begrenzenden innenseitigen Begrenzungswand (13) versehen ist, die in den Befestigungsabschnitt (11) übergeht.

9. Schaltschrank oder Rack nach Anspruch 8, **dadurch gekennzeichnet, dass** der Anlageabschnitt (12) und die innenseitige Begrenzungswand 13 im Querschnitt der Aufnahme (14) rechtwinklig zueinander angeordnet sind, wobei der Anlageabschnitt (12) parallel zur Montageebene (5) ausgerichtet ist und die Begrenzungswand (13) rechtwinklig in den Befestigungsabschnitt (11) übergeht.

10. Schaltschrank oder Rack nach einem der Ansprüche 7 bis 9, **dadurch gekennzeichnet, dass** die Antennenleiste (30) quadratischen oder rechteckförmigen Querschnitt besitzt.

11. Schaltschrank oder Rack nach einem der Ansprüche 7 bis 10, **dadurch gekennzeichnet, dass** in dem Anlageabschnitt (12) eine Haltelochreihe (12.1) mit in regelmäßigem Rasterabstand angeordneten Haltelöchern (12.2) angeordnet ist, wobei die Haltelöcher (12.2) quadratisch oder rechteckförmig mit in Längsrichtung des Montageprofils (10) verlaufenden Längsseiten ausgebildet sind,
dass die Antennenleiste (30) auf ihrer dem Anlageabschnitt (12) zugekehrten Rückseite mit Haltehaken (33) versehen ist, die auf den Abstand der Haltelöcher (12.2) oder ein Vielfaches davon abgestimmt sind und vertikale Hakenabschnitte aufweisen, die eine geringere Länge besitzen als die lichte Öffnungsweite der Haltelöcher (12.2) in vertikaler Richtung und die soweit von der rückseitigen Außenfläche der Antennenleiste (30) beabstandet sind, dass sie einen die Haltelöcher (12.2) umgebenden Wandbereich des Anlageabschnitts (12) mit einer Klemmkraft hintergreifen, und dass im Inneren der Antennenleiste (30) im Raster einer Höheneinheit HE oder einem ganzzahligen Vielfachen oder gleichmäßigen Teilabstand davon in Längsrichtung der Antenneneinheit (30) voneinander beabstandete Antennenelemente angeordnet sind.

12. Schaltschrank oder Rack nach einem der Ansprüche 7 bis 11, **dadurch gekennzeichnet, dass** die Antennenleiste (30) bezüglich ihrer Einbaulage auf ihrer Frontseite mit einem daran fest oder abnehmbar angebrachten Abdeckteil (32) versehen ist, das zumindest abschnittsweise transparent ausgebildet ist,
dass im Inneren der Antennenleiste (30) Leuchtelemente (31) angeordnet sind, die in Längsrichtung der Antennenleiste (30) in gleichmäßigem Rasterabstand im Raster einer Höheneinheit HE oder einem ganzzahligen Vielfachen oder gleichmäßigen Teilabstand davon angeordnet, getrennt ansteuerbar und im Leuchtzustand durch das transparente Abdeckteil (30) positionsgenau sichtbar sind, und
dass der Tragabschnitt (41) lichtundurchlässig ausgebildet ist und zumindest ein Leuchtelement (31) frontseitig abdeckt.

## Claims

1. A switchgear cabinet or rack comprising a mounting unit, the front of which has vertical mounting profiles (10, 10') that laterally delimit an installation space (6) for installed user-side units (20), said profiles having flat fixing sections (11) that lie on a front mounting plane (5) and that are used to fix laterally projecting mounting sections (21) of the installed units (20), and comprising components of a detection device for determining the presence of an installed unit (20) in an installation position of the cabinet frame (6), wherein the components of the detection device have a vertical antenna strip (30) that is attached to a mounting profile (10) and contains antenna elements arranged therein and code carriers that are designed as transponder elements (44) and are provided on the installed units (20), wherein the relevant transponder element (44) is attached to the mounting section (21) of the associated installed unit (20) that adjoins the antenna strip (30) by means of a retaining element (40) via a connecting section (42), and wherein the retaining element (40) has a support section (41) that adjoins the connecting section (42) and projects outwards, parallel to the mounting plane, wherein the transponder element (44) is attached to the support section, **characterized in that** the respective transponder element (44) is located on a laterally protruding tongue-like support section (41) overlapping the antenna strip(30) inserted into the mounting profile (10) at the front.

2. The switchgear cabinet or rack of claim 1, **characterized in that** said retaining element (40) is flat and is arranged with its connecting section (42) on the rear of said mounting section (21) which is also flat, and is pressed against the front of said fixing section (11) together therewith.

3. The switchgear cabinet or rack of claim 1 or 2, **characterized in that** said connecting section (42) is adhesively bonded to the mounting section (21).

4. The switchgear cabinet or rack of any of the preceding claims, **characterized in that** said fixing section (11) is provided with a row of holes (11.1) having fixing holes (11.2) arranged in a regular grid spacing,
one or more mounting holes (21.1) harmonized with the position of the fixing holes (11.2) is/are arranged in said mounting section (21) and
also in said connecting section (42), openings (43) harmonized with the position of the mounting holes (21.1) are arranged.

5. The switchgear cabinet or rack of any of the preceding claims, **characterized in that** said connecting section (42) extends in longitudinal direction of said mounting profile (10) over the height of mounting section (21), in particular a unit of height HE, and extends to the outer side to the free edge of the mounting section (21).

6. The switchgear cabinet or rack of any of the preceding claims, **characterized in that** said support section (41) extends in its height over a fraction of said connecting section (42).

7. The switchgear cabinet or rack of any of the preceding claims, **characterized in that** said antenna strip (30) lies with its front face on the mounting plane (5) or is set back in relation thereto by a maximum of 10 mm.

8. The switchgear cabinet or rack of claim 7, **characterized in that** said mounting profile (10) comprises a cavity (14) at least partly adapted to the section of said antenna strip (30), with an abutment section (12) set back in relation to the mounting plane (5) at least by the cross section depth of the antenna strip (30) and with an inner boundary wall (13) delimiting said cavity (14) on its face facing the installation space (6) which wall merges into said fixing section (11).

9. The switchgear cabinet or rack of claim 8, **characterized in that** said abutment section (12) and said inner boundary wall (13) are perpendicularly arranged in cross section of said cavity (14), wherein said abutment section (12) is oriented parallel to said mounting plane (5) and said boundary wall (13) merges perpendicularly into said fixing section (11).

10. The switchgear cabinet or rack of any of claims 7 to 9, **characterized in that** said antenna strip (30) possesses square or rectangular cross section.

11. The switchgear cabinet or rack of any of claims 7 to 10, **characterized in that** a row of retaining holes (12.1) is arranged in said abutment section (12) having retaining holes (12.2) arranged in regular grid spacing, wherein said retaining holes (12.2) are square or rectangular with longitudinal faces running in longitudinal direction of said mounting profile (10), said antenna strip (30) is provided with retaining hooks (33) on the rear facing the abutment section (12) which are harmonized to the spacing of said retaining holes (12.2) or a multiple thereof and comprise vertical hook sections which possess a smaller length than the clear opening width of said retaining hole (12.2) in vertical direction and which are spaced from the rear outer face of said antenna strip (30) to engage behind a wall region of said abutment section (12) surrounding said retaining holes (12.2) with a clamping force, and
spaced antenna elements are arranged in the interior of said antenna strip (30) within grid of a unit of height HE or an integer multiple thereof or in regular partial spacing thereof in longitudinal direction of said antenna unit (30).

12. The switchgear cabinet or rack of any of claims 7 to 11, **characterized in that** said antenna strip (30) is provided with a fixedly or removably attached cover part (32) at its front face in relation to its installation position which is at least in sections transparent,
illuminating elements (31) are arranged in the interior of said antenna strip (30) which are arranged in longitudinal direction of said antenna strip (30) in a regular grid spacing within grid of a unit of height HE or an integer multiple thereof or in regular partial spacing thereof, are individually controllable and are accurately visible in an illuminating state through said transparent cover part (30) and
said support section (41) is opaque and covers at least one illuminating element (31) at its front face.

## Revendications

1. Armoire électrique ou rack comprenant un dispositif de montage, qui comporte un espace de montage (6) pour des profilés de montage (10, 10') verticaux, qui délimitent latéralement du côté frontal des unités encastrables (20) du côté utilisateur et comportent des tronçons de fixation (11) plats, disposés dans un plan de montage (5) du côté frontal et utilisés pour y appliquer des tronçons de montage (21) latéralement saillants sur les unités encastrables (20), et comprenant des composants d'un dispositif de détection permettant de constater si une unité encastrable (20) est présente ou non à un emplacement de montage dans l'espace de montage (6), lesdits composants du dispositif de détection comportant une latte d'antenne (30), qui est appliquée sur un profilé de montage (10), en s'étendant verticalement, avec des éléments d'antenne disposés dans celle-ci, et comportant des supports de code réalisés sous forme d'éléments transpondeurs (44), disposés sur les unités encastrables (20), chaque élément transpondeur (44) étant appliqué au moyen d'un élément de retenue (40) sur le tronçon de montage (21), adjacent à la latte d'antenne (30), de l'unité encastrable (20) correspondante par l'intermédiaire d'un tronçon de liaison (42), l'élément de retenue (40) comportant une partie de support (41) saillante vers l'extérieur parallèlement au plan de montage, dans le prolongement du tronçon de liaison (42), **caractérisé en ce que** l'élément transpondeur (44) respectif se situe sur une partie de support (41) saillante latéralement en forme de patte qui recouvre du côté frontal la latte d'antenne (30) insérée dans le profilé de montage (10).

2. Armoire électrique ou rack selon la revendication 1, **caractérisé en ce que** l'élément de retenue (40) est plat et est disposé avec son tronçon de liaison (42) sur la face arrière également plate du tronçon de montage (21) et est poussé avec celui-ci contre la face avant du tronçon de fixation (11).

3. Armoire électrique ou rack selon la revendication 1 ou 2, **caractérisé en ce que** le tronçon de liaison (42) est collé sur le tronçon de montage (21).

4. Armoire électrique ou rack selon l'une quelconque des revendications précédentes, **caractérisé en ce que** le tronçon de fixation (11) est muni d'une rangée (11.1) de trous de fixation (11.2) disposés selon une trame à même distance les uns des autres, **en ce qu'**un ou plusieurs trous de montage (21.1), ajustés à la position des trous de fixation (11.2), est/sont disposé(s) dans le tronçon de montage (21), et **en ce que** des orifices (43) ajustés à la position des trous de montage (21.1) sont disposés également dans le tronçon de liaison (42).

5. Armoire électrique ou rack selon l'une quelconque des revendications précédentes, **caractérisé en ce que** le tronçon de liaison (42) s'étend dans le sens longitudinal du profilé de montage (10) sur la hauteur du tronçon de montage (21), en particulier une unité de hauteur HE, et s'étend vers le côté extérieur jusqu'au bord libre du tronçon de montage (21).

6. Armoire électrique ou rack selon l'une quelconque des revendications précédentes, **caractérisé en ce que** la partie de support (41) s'étend en hauteur sur une fraction du tronçon de liaison (42).

7. Armoire électrique ou rack selon l'une quelconque des revendications précédentes, **caractérisé en ce que** la latte d'antenne (30) avec sa face frontale se situe dans le plan de montage (5) ou est disposée en retrait par rapport à celui-ci sur 10 mm maximum.

8. Armoire électrique ou rack selon la revendication 7, **caractérisé en ce que** le profilé de montage (10) comporte un logement (14), ajusté au moins partiellement à la section transversale de la latte d'antenne (30), muni d'une partie d'appui (12) disposée en retrait par rapport au plan de montage (5), au moins sur la profondeur de la section transversale de la latte d'antenne (30), et muni d'une paroi de délimitation (13) intérieure, qui délimite le logement (14) sur le côté de celui-ci orienté vers l'espace de montage (6) et qui se prolonge par le tronçon de fixation (11).

9. Armoire électrique ou rack selon la revendication 8, **caractérisé en ce que** la partie d'appui (12) et la paroi de délimitation (13) intérieure sont disposées dans la section transversale du logement (14) perpendiculairement l'une à l'autre, la partie d'appui (12) étant orientée parallèlement au plan de montage (5) et la paroi de délimitation (13) se prolongeant en angle droit par le tronçon de fixation (11).

10. Armoire électrique ou rack selon l'une quelconque des revendications 7 à 9, **caractérisé en ce que** la latte d'antenne (30) a une section carrée ou rectangulaire.

11. Armoire électrique ou rack selon l'une quelconque des revendications 7 à 10, **caractérisé en ce que** dans la partie d'appui (12) est disposée une rangée (12.1) de trous de retenue (12.2), disposés selon une trame à même distance les uns des autres, lesdits trous de retenue (12.2) étant carrés ou rectangulaires avec des côtés longitudinaux orientés dans le sens longitudinal du profilé de montage (10), **en ce que** la latte d'antenne. (30), sur sa face arrière orientée vers la partie d'appui (12), est munie de crochets de retenue (33) qui sont ajustés à la distance entre les trous de retenue (12.2) ou un multiple de celle-ci et comportent des tronçons de crochets verticaux, dont la longueur est inférieure à la largeur intérieure des trous de retenue (12.2) dans le sens vertical et qui sont situés par rapport à la surface extérieure arrière de la latte d'antenne (30) à une distance telle qu'ils enserrent par l'arrière avec une force de serrage la zone de paroi, entourant les trous de retenue (12.2), de la partie d'appui (12), et **en ce qu'**à l'intérieur de la latte d'antenne (30) sont disposés des éléments d'antenne écartés les uns des autres dans le sens longitudinal de l'unité d'antenne (30) selon une trame d'une unité de hauteur HE ou selon un multiple entier de celle-ci ou à une distance partielle régulière de celle-ci.

12. Armoire électrique ou rack selon l'une quelconque des revendications 7 à 11, **caractérisé en ce que** la latte d'antenne (30) est munie sur sa face frontale, par rapport à sa position de montage, d'un élément formant cache (32) qui est posé de manière fixe ou amovible et est transparent au moins par zones, **en ce qu'**à l'intérieur de la latte d'antenne (30) sont disposés des éléments d'éclairage (31), qui sont situés dans une trame à même distance les uns des autres selon une unité de hauteur HE ou un multiple entier de celle-ci ou à une distance partielle régulière de celle-ci, peuvent être commandés séparément et, en position éclairée, sont visibles exactement dans leur position à travers l'élément formant cache (30) transparent, et **en ce que** la partie de support (41) est réalisée de manière à ne pas laisser passer la lumière et couvre du côté frontal au moins un élément d'éclairage (31).
